# EUROPÄISCHE PATENTANMELDUNG

(11) **EP 1 076 367 A2**
(43) Veröffentlichungstag der Anmeldung: **14.02.2001**
(21) Anmeldenummer: 00117140.4
(22) Anmeldetag: 10.08.2000
(51) Int. Cl.: H01L 41/083

(54) **Piezoaktor bestehend aus einem Stapel von Hohlkörpern**

(30) Priorität: 13.08.1999 DE 19938457
(71) Anmelder: ROBERT BOSCH GMBH, 70442 Stuttgart (DE)
(72) Erfinder: Boecking, Friedrich, 70499 Stuttgart (DE)

(57) **Zusammenfassung**

Es wird ein Piezoaktor, beispielsweise zur Betätigung eines mechanischen Bauteils, vorgeschlagen, mit einem Aufbau von Einzelaktoren (2;5;7) und zugeordneten Innenelektroden (3,4) über die bei einer wechselseitigen seitlichen Kontaktierung mit Außenelektroden (9,10) eine elektrische Spannung zuführbar ist. Die Einzelaktoren bestehen aus Hohlkörpern (2;5;7), bei denen die eine Innenelektrode (4) am Innenumfang und die andere Innenelektrode (3) am Außenumfang angeordnet ist und sind in der Regel jeweils übereinander und nebeneinander gestapelt. Die Hohlkörper können dabei Hohlzylinder (2) oder Quader (5;7) mit einer zylindrischen oder einer im Querschnitt rechteckigen Innenausnehmung sein.

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristalistruktur aufgebaut, werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses Piezoaktors erfolgt in üblicher Weise durch Übereinanderstapeln mehreren Piezoschichten (Multilayer-Aktoren), wobei die Elektroden, über die die elektrische Spannung aufgebracht wird, jeweils zwischen den Schichten angeordnet werden.

Solche Piezoaktoren können beispielsweise für den Antrieb von kraftausgeglichenen Schaltventilen bei Kraftstoffeinspritzsystemen in Kraftfahrzeugen vorgesehen werden. Das bekannte Stapeln der Schichten erfordert einen relativ großen Herstellungsaufwand, wobei insbesondere auch die optimale Einstellung des für den jeweiligen Anwendungsfall benötigten Hubes, der Hubgeschwindigkeit und das Kraftvermögen durch eine geeignete geometrische Form des gesamten Lagen- bzw. Schichtaufbaus schwierig ist. Es ist dabei für sich gesehen auch bekannt, verschiedene, in bestimmten Wirkungsachsen auftretende Piezoeffekte, wie z.B. den λ₃₁ Effekt, auszunutzen.

### Vorteile der Erfindung

Der eingangs beschriebene Piezoaktor mit einem Aufbau von Einzelaktoren und zugeordneten Innenelektroden, der beispielsweise zur Betätigung eines mechanischen Bauteils verwendbar sein kann, ist in vorteilhafter Weise mit dadurch weitergebildet, dass die Einzelaktoren aus Hohlkörpern bestehen, bei denen die eine Innenelektrode am Innenumfang und die andere Innenelektrode am Außenumfang angeordnet ist.

Die Einzelaktoren sind bei einer bevorzugten Ausführungsform jeweils übereinander und nebeneinander gestapelt. Durch eine derart optimierte Stapelform kann hier auch der sog. λ₃₃ Piezoeffekt ausgenutzt werde, der z.B. ein um 50% vergrößertes Hubvermögen gegenüber dem schon eingangs erwähnten λ₃₁ Effekt aufweist. Als mögliche geometrische Gestaltung der Hohlkörper bieten sich in vorteilhafter Weise Hohlkörper als Hohlzylinder oder Hohlkörper als Quader mit einer zylindrischen oder mit einer im Querschnitt rechteckigen Innenausnehmung an.

Der erfindungsgemäße Piezoaktor weist dabei insbesondere für kleine zu erzeugende Kräfte und schnelle Hübe eine einfache Kontur auf, wobei die Größe der Einzelaktoren im Millimeterbereich liegt. Je nach Anwendungsfall kann dabei über die Anzahl der Einzelaktoren in der Hubrichtung der mögliche Hub und über die Anzahl in der Breite, also quer zur Hubrichtung, das Kraftvermögen eingestellt werden.

Auf einfache Weise kann die Kontur der Hohlkörper an den Seiten, an denen die Kontaktierung der Innenelektroden mit den Außenelektroden vorgenommen wird, so gestaltet sein, dass an einer Seite die Innenelektroden am Innenumfang und an der anderen Seite die Innenelektroden am Außenumfang einen vorgegebenen Bereich hervorstehen. Somit kann die wechselseitige Kontaktierung der Innenelektroden einfach vorgenommen werden, so dass jeweils eine elektrische Spannung zwischen der Innenelektrode am Innenumfang und der Innerlelektrode am Außenumfang der Einzelaktoren von seitlichen Anschlüssen zuführbar ist, die ein elektrisches Feld zur Bildung des Piezoeffekts in jedem Einzelaktor entstehen lässt.

Bei einem besonders vorteilhaften Verfahren zur Herstellung eines Piezoaktor der zuvor beschriebenen Art werden aus einem Piezokeramikmaterial durch Extrusion die Hohlkörper gebildet. Zur Bildung der Innenelektroden werden die Hohlkörper am Innen- und am Außenumfang komplett metallisiert und anschließend die aus den Hohlkörpern gebildeten Einzelaktoren in einem Sinterprozess miteinander verbacken. Die Außenelektroden an den Seitenflächen werden durch Löten mit den jeweils zugehörigen Innenelektroden kontaktiert und an den Außenelektroden sind dann die elektrischen Anschlüsse für die Zuführung einer elektrischen Spannung anbringbar.

Diese und weitere Merkmale von bevorzugten Weiterbildungen der Erfindung gehen außer aus den Ansprüchen auch aus der Beschreibung und den Zeichnungen hervor, wobei die einzelnen Merkmale jeweils für sich allein oder zu mehreren in Form von Unterkombinationen bei der Ausführungsform der Erfindung und auf anderen Gebieten verwirklicht sein und vorteilhafte sowie für sich schutzfähige Ausführungen darstellen können, für die hier Schutz beansprucht wird.

### Zeichnung

Ausführungsbeispiele des erfindungsgemäßen Piezoaktors mit Hohlkörpern als Einzelaktoren werden anhand der Zeichnung erläutert. Es zeigen:
Figur 1 eine Ansicht mit hohlzylindrischen Hohlkörpern;
Figur 2 eine Ansicht mit quaderförmigen Hohlkörpern und einer zylindrischen Innenausnehmung;
Figur 3 eine Ansicht mit quaderförmigen Hohlkörpern und einer Innenausnehmung mit rechteckigem Querschnitt und
Figur 4 einen Detailschnitt entlang der Schnittlinie A-A aus der Figur 1 oder 2 mit einer Kontaktierung der Innenelektroden.

### Beschreibung der Ausführungsbeispiele

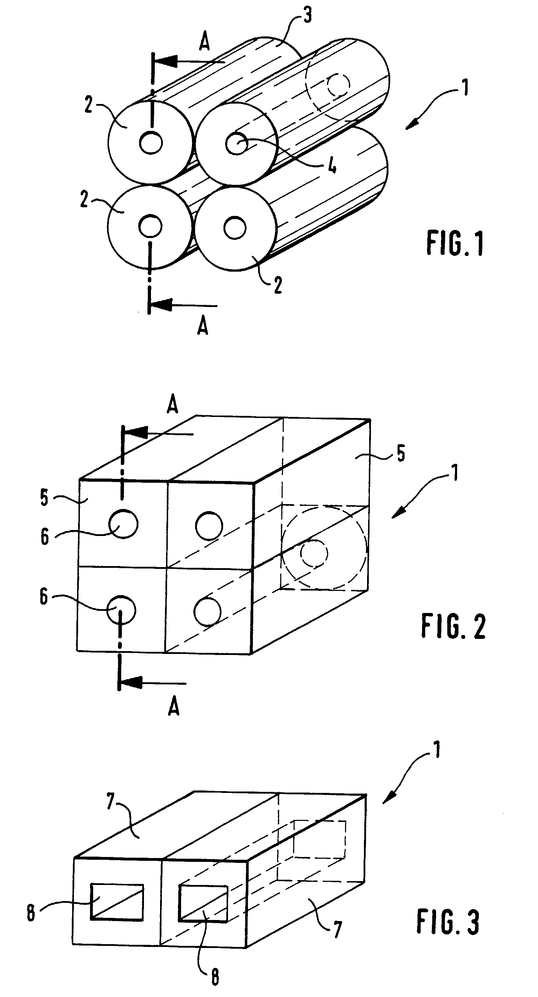

In Figur 1 ist ein Piezoaktor 1 gezeigt, der aus Einzelaktoren 2 aus einem Keramikmaterial mit einer geeigneten Kristalistruktur aufgebaut ist, so dass unter Ausnutzung des sogenannten Piezoeffekts bei Anlage einer äußeren elektrischen Spannung an Innenelektroden eine mechanische Reaktion der Einzelaktoren und somit des gesamten Piezoaktors 1 erfolgt.

Bei der Figur 1 sind die Einzelaktoren 2 hohlzylindrische Hohlkörper, die auf dem inneren Umfang jeweils eine Innenelektrode 3 und auf dem äußeren Umfang die jeweils andere Innenelektrode 4 tragen. Dieses Ausführungsbeispiel kann, wie auch die noch folgend beschriebenen Ausführungsbeispiele, aus einem Piezokeramikmaterial durch Extrusion hergestellt werden. Die Innenelektroden 3 und 4 werden durch eine Metallisierung der jeweiligen Umfangsflächen gebildet. Abschließend sind die Einzelaktoren 2 in einem Sinterprozess miteinander verbacken und mit hier nicht ersichtlichen Außenelektroden und elektrischen Anschlüssen für die Zuführung einer elektrischen Spannung versehen worden.

Zwischen den Innenelektroden 3 und 4 wirkt hierbei, bei Anlage einer elektrischen Spannung, das größte Feld und damit die größte mechanische Dehnung aufgrund des Piezoeffekts. In der 90° Achse wirkt dabei der Dehnungseffekt nur halb so stark, da die Feldlinien immer zwischen den Elektroden laufen und damit senkrecht (90°) zur Elektrode die Ausrichtung behindert ist.

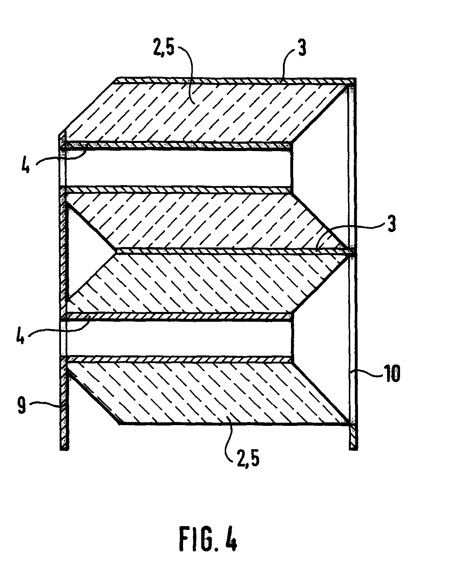

In Figur 2 ist ein anderes Ausführungsbeispiel hinsichtlich der geometrischen Form von Einzelaktoren 5 mit einer zylindrischen Innenausnehmung 6 und in Figur 3 ist ein weiteres Ausführungsbeispiel hinsichtlich der geometrischen Form von Einzelaktoren 7 mit jeweils einer Innenausnehmung 8, die einen rechteckigen Querschnitt aufweist, gezeigt.

Aus einem Detailschnitt nach Figur 4 ist die Kontur der Hohlkörper 2 aus der Figur 1 oder der Hohlkörper 5 aus der Figur 2 entlang einer Schnittlinie A-A zu erkennen. Die Seiten der Hohlkörper 2 bzw. 5 oder 7, an denen die Kontaktierung der Innenelektroden 3 und 4 mit Außenelektroden 9 und 10 vorgenommen wird, sind hierbei so gestaltet, dass an einer Seite jeweils die Innenelektrode 4 und an der anderen Seite jeweils die Innenelektrode 3 hervorsteht. Somit kann die wechselseitige Kontaktierung der Innenelektroden 3 und 4 mit einem relativ einfachen Bearbeitungsgang vorgenommen werden und damit jeweils eine elektrische Spannung zwischen der Innenelektrode 4 am Innenumfang und der Innenelektrode 3 am Außenumfang der Einzelaktoren 2 bzw. 5 oder 7 ansteht. Über hier nicht dargestellte seitliche Anschlüssen ist diese Spannung an die Außenelektroden 9 und 10 führbar.

## Patentansprüche

1. Piezoaktor, mit
- einem Aufbau von Einzelaktoren (2;5;7) und zugeordneten Innenelektroden (3,4),
- einer wechselseitigen seitlichen Kontaktierung der Innenelektroden (3,4) über Außenelektroden (9,10), über die eine elektrische Spannung zuführbar ist, wobei
- die Einzelaktoren aus Hohlkörpern (2;5;7) bestehen, bei denen die eine Innenelektrode (4) am Innenumfang und die andere Innenelektrode (3) am Außenumfang angeordnet ist.

2. Piezoaktor nach Anspruch 1, **dadurch gekennzeichnet, dass**
- die Einzelaktoren (2;5;7) jeweils übereinander und nebeneinander gestapelt sind.

3. Piezoaktor nach einem der vorhergehenden Ansprüche, **dadurch gekennzeichnet, dass**
- die Hohlkörper (2) Hohlzylinder sind.

4. Piezoaktor nach einem der Ansprüche 1 oder 2, **dadurch gekennzeichnet, dass**
- die Hohlkörper (5) Quader mit einer zylindrischen Innenausnehmung sind.

5. Piezoaktor nach einem der Ansprüche 1 oder 2, **dadurch gekennzeichnet, dass**
- die Hohlkörper (7) Quader mit einer im Querschnitt rechteckigen Innenausnehmung sind.

6. Piezoaktor nach einem der vorhergehenden Ansprüche, **dadurch gekennzeichnet, dass**
- die Kontur der Hohlkörper (2;5;7) an den Seiten, an denen die Kontaktierung der Innenelektroden (3,4) mit den Außenelektroden (9,10) vorgenommen wird, so gestaltet ist, dass an einer Seite die Innenelektroden (4) am Innenumfang und an der anderen Seite die Innenelektroden (3) am Außenumfang einen vorgegebenen Bereich hervorstehen, zur Herstellung eines Kontaktes mit den jeweiligen Außenelektroden (9,10).

7. Verfahren zur Herstellung eines Piezoaktor nach einem der vorhergehenden Ansprüche, **dadurch gekennzeichnet, dass**
- aus einem Piezokeramikmaterial durch Extrusion die Hohlkörper (2;5;7) gebildet werden, dass
die Hohlkörper (2;5;7) am Innen- und am Außenumfang komplett metallisiert werden, zur Bildung der Innenelektroden (3,4), dass
die aus den Hohlkörpern gebildeten Einzelaktoren (2;5;7) in einem Sinterprozess miteinander verbacken werden und dass
die Außenelektroden (9,10) durch Löten mit den jeweils zugehörigen Innenelektroden (3,4) kontaktiert werden.
